(19) Europäisches Patentamt
European Patent Office
Office européen des brevets

(11) **EP 4 675 874 A1**

(12) **EUROPÄISCHE PATENTANMELDUNG**

(43) Veröffentlichungstag:
**07.01.2026  Patentblatt 2026/02**

(21) Anmeldenummer: **24186850.4**

(22) Anmeldetag: **05.07.2024**

(51) Internationale Patentklassifikation (IPC):
**H02H 3/087** (2006.01)  **H03K 17/12** (2006.01)
**H03K 17/082** (2006.01)  **H03K 17/14** (2006.01)

(52) Gemeinsame Patentklassifikation (CPC):
**H02H 3/087; H02H 3/05; H03K 17/0822;**
**H03K 17/122; H03K 17/145;** H02M 3/1584

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH MA MD TN**

(71) Anmelder: **Siemens Aktiengesellschaft
80333 München (DE)**

(72) Erfinder: **Troyer, Markus
3040 Neulengbach (AT)**

(74) Vertreter: **Siemens Patent Attorneys
Postfach 22 16 34
80506 München (DE)**

(54) **LASTAUSGLEICH VON PARALLEL GESCHALTETEN AUSGANGSKANÄLEN EINER STROMVERSORGUNGSVORRICHTUNG**

(57) Die Erfindung betrifft eine Stromversorgungsvorrichtung, insbesondere eine elektronische Sicherung (ES) für eine Energieversorgung, umfassend eine erste Menge ($M_1$) an Ausgangskanälen ($Ch_1...Ch_n$) und eine Regeleinheit (RE) zum Lastausgleich zwischen den Ausgangskanälen ($Ch_1...Ch_n$) der ersten Menge ($M_1$), wobei
- eine erste Anzahl ($N_{M1}$) an Ausgangskanälen ($Ch_1...Ch_n$) in der ersten Menge ($M_1$) größer gleich zwei ist,
- die Ausgangskanäle ($Ch_1...Ch_n$) der ersten Menge ($M_1$) jeweils einen Stromregler ($REG$-$I_1...REG$-$I_n$) und ein Schaltelement ($SE_1...SE_n$) umfassen,
- die Stromregler ($REG$-$I_1...REG$-$I_n$) dazu ausgebildet sind, das Schaltelement ($SE_1...SE_n$) in ihrem jeweiligen Ausgangskanal ($Ch_1...Ch_n$) anzusteuern,
- die Ausgangskanäle ($Ch_1...Ch_n$) der ersten Menge ($M_1$) jeweils einen momentanen Ausgangsstrom ($I_{Ch1}...I_{Chn}$) und einen Nennstrom ($I_{Ch1,N}...I_{Chn,N}$) aufweisen,
- die Ausgangskanäle ($Ch_1...Ch_n$) der ersten Menge ($M_1$) parallel schaltbar sind,
und wobei die Regeleinheit (RE) dazu ausgebildet ist, im Fall einer Parallelschaltung von zumindest zwei Ausgangskanälen ($Ch_1...Ch_n$) der ersten Menge ($M_1$):
- die momentanen Ausgangsströme ($I_{Ch1}...I_{Chn}$) der Ausgangskanäle ($Ch_1...Ch_n$) der ersten Menge ($M_1$) zu erfassen,

- Ausgangskanal-Auslastungsgrade ($AG_{Ch1}...AG_{Chn}$) der Ausgangskanäle ($Ch_1...Ch_n$) der ersten Menge ($M_1$) zu ermitteln, wobei ein jeweiliger Ausgangskanal-Auslastungsgrad ($AG_{Ch1}...AG_{Chn}$) ein Verhältnis zwischen dem momentanen Ausgangsstrom ($I_{Ch1}...I_{Chn}$) und dem Nennstrom ($I_{Ch1,N}...I_{Chn,N}$) des jeweiligen Ausgangskanals ($Ch_1...Ch_n$) ist,
- eine zweite Menge ($M_2$) an Ausgangskanälen ($Ch_1...Ch_n$) zu ermitteln, wobei die zweite Menge ($M_2$) eine Teilmenge der ersten Menge ($M_1$) ist, wobei eine zweite Anzahl ($N_{M2}$) der Ausgangskanäle ($Ch_1...Ch_n$) in der zweiten Menge ($M_2$) zumindest um eins kleiner ist als die erste Anzahl ($N_{M1}$), wobei die zweite Menge ($M_2$) zumindest jenen Ausgangskanal ($Ch_1...Ch_n$) mit dem größten Ausgangskanal-Auslastungsgrad ($AG_{Ch1}...AG_{Chn}$) umfasst und zumindest jenen Ausgangskanal ($Ch_1...Ch_n$) mit dem niedrigsten Ausgangskanal-Auslastungsgrad ($AG_{Ch1}...AG_{Chn}$) nicht umfasst, und
- die Stromregler ($REG$-$I_1...REG$-$I_n$) der Ausgangskanäle ($Ch_1...Ch_n$) der zweiten Menge ($M_2$) derart anzusteuern, dass die Ausgangskanal-Auslastungsgrade ($AG_{Ch1}...AG_{Chn}$) der Ausgangskanäle ($Ch_1...Ch_n$) der zweiten Menge ($M_2$) abnehmen und ein Lastausgleich zwischen den Ausgangskanälen ($Ch_1...Ch_n$) der ersten Menge ($M_1$) stattfindet.

**(Forts. nächste Seite)**

# FIG 2

**Beschreibung**

Die gegenständliche Erfindung betrifft allgemein das Gebiet der Elektrotechnik, insbesondere den Bereich der Leistungselektronik sowie Stromversorgungseinrichtungen. Im Speziellen bezieht sich die vorliegende Erfindung auf eine Stromversorgungsvorrichtung, insbesondere eine elektronische Sicherung, bzw. ein Verfahren zum Lastausgleich von parallel geschalteten Ausgangskanälen Stromversorgungsvorrichtung, insbesondere einer elektronischen Sicherung.

Stand der Technik

Im Folgenden wird die Erfindung anhand des Beispiels von elektronischen Sicherungen beschrieben. Die genannten Probleme ergeben sich jedoch bei Stromversorgungsvorrichtungen im Allgemeinen. Die Lösung der genannten Probleme durch die Erfindung kann auch für Stromversorgungsvorrichtungen angewendet werden.

Eine Parallelschaltung von Ausgangskanälen in elektronischen Sicherungen ermöglicht eine kostengünstige Leistungserweiterung von einzelnen Ausgangskanälen von elektronischen Sicherungen. Da in der Applikation die Ausgangsleistungen der einzelnen Ausgangskanäle stark variieren kann, ist die Definition des Nennstroms in vielen Fällen strittig. Während Steuer- und Regeleinrichtung samt Sensorik mit bereits geringen Strömen auskommen, können Antriebsanwendungen durchaus 20A und mehr erfordern.

Elektronische Sicherungen bieten gerade hierfür mehrere Ausgangskanäle, um eben verschieden Leistungskreise aufbauen zu können und dadurch die Anlagenverfügbarkeit durch Selektivität zu erhöhen. Da hier aber einer der Vorteile von elektronische Sicherungen gegenüber konventionellen Schmelzsicherungen bzw. Leitungsschutzschaltern liegt, muss dies im Schaltungsdesign mitberücksichtigt werden.

Hohe Nennströme erfordern leistungsstärkere und damit kostenintensivere elektronische Schalter bzw. MOSFETs und stellen zudem eigene Anforderungen an die Schaltungskonzeption. Niedrigere Ströme bspw. erfordern höherohmige Shunts, welche in Hochstromanwendungen wiederum zu viel Verlustleistung verursachen.

In der Praxis haben sich Nennströme von ca. 10A etabliert, ebenfalls nachgefragt sind Geräte mit 5A bzw. 3A in NEC Class 2 Anwendungen. Während die beiden Letztgenannten eher für Steuer-, Regel und Visualisierungsaufgaben zum Einsatz kommen, ist eine Leistungserweiterung durch Parallelschaltung für solche Geräte eher uninteressant.

In Anwendungen mit 10A Nennstrom kann man durchaus Interesse für Leistungserweiterungen finden. Wie eingangs erwähnt, bietet hierfür die Parallelschaltung von einzelnen Ausgangskanälen eine kostengünstige Alternative zu aufwändigen Konstruktionen, welche mehrere Kanäle mit unterschiedlichen Nennströmen beherbergen. Derlei Konstruktionen sind sinnvoll in spezifischen Anwendungen, aber eher schwierig in der Gestaltung, da die Flexibilität in den Einsatzmöglichkeiten stark eingeschränkt wäre. Hierfür seien Temperatur-Deratings, bauliche Gegebenheiten, etc. als Beispiele angemerkt.

Im Parallelbetrieb von MOSFET sind zwei Effekte maßgeblich für eine ungleiche Stromaufteilung zwischen den Zweigen. Im dynamischen Schaltbetrieb wird die Stromaufteilung von der Thresholdspannung bestimmt. Der MOSFET mit der geringeren Einschaltschwelle schaltet als erstes ein und als letztes aus und übernimmt dadurch einen Großteil der Schaltverluste. Da die Thresholdspannung mit steigender Temperatur sinkt, verstärkt sich dieser Effekt mit steigender Betriebstemperatur.

Im Stationärbetrieb bestimmt der jeweilige $R_{DS,on}$ die Stromaufteilung. Der MOSFET mit dem geringeren Widerstand übernimmt den größeren Stromfluss. Allerdings erhöht sich der $R_{DS,on}$ mit steigender Temperatur, wodurch dadurch ein Ausgleichseffekt erzielt wird. Durch die höhere Verlustleistung erwärmt sich der MOSFET mit höherem Strom stärker, wodurch sein $R_{DS,on}$ hochohmiger wird und den Stromfluss dadurch vermindert.

Dennoch kann in der Realisierung der Schaltung nicht davon ausgegangen werden, dass die Thermik allein ausreicht, um die Ströme in den Parallelzweigen auszugleichen. Einerseits unterliegt der $R_{DS,on}$ als Bauteilparameter gewissen Fertigungstoleranzen, andererseits reichen bereits geringe Unterschiede im Schaltungsdesign, ferner zusätzliche Toleranzen sich zusätzlich im Parallelzweig befindlichen Bauteile, um eine ungleiche Stromaufteilung zu bewirken.

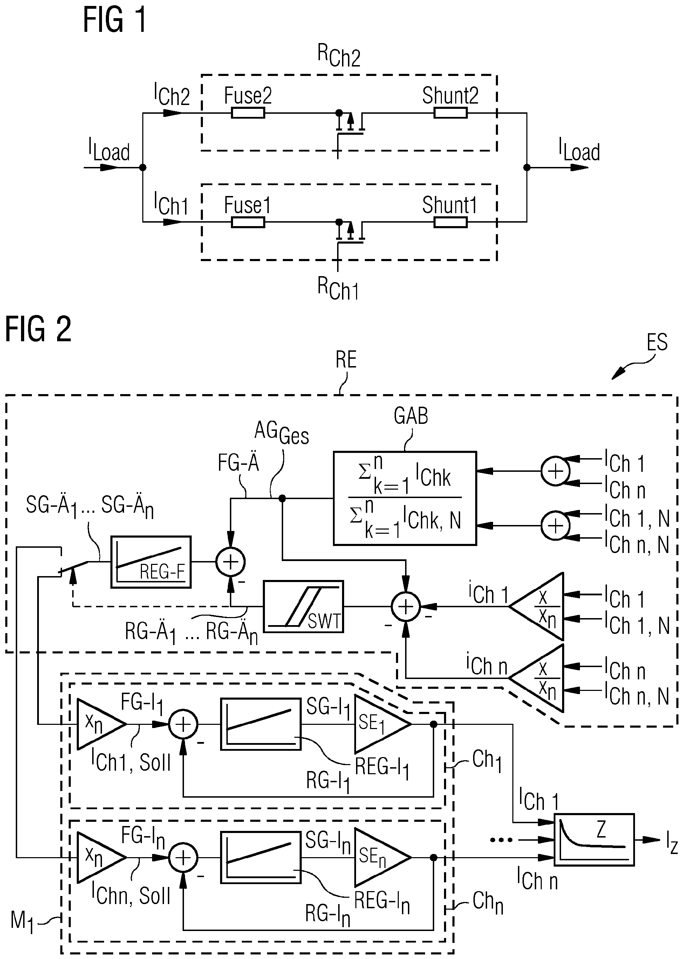

Dieser Zusammenhang ist in Fig. 1 dargestellt. Eine Überprüfung mittels Stromteilerregel zeigt mit fiktiven Werten für einen ersten Ausgangskanal

$$I_{Ch1} = I_{Load} * \frac{R_{Ch2}}{R_{Ch1} + R_{Ch2}} = 10A * \frac{4{,}2m\Omega}{3{,}4m\Omega + 4{,}2m\Omega} = 5{,}526A$$

und für einen zweiten Ausgangskanal

$$I_{Ch2} = I_{Load} * \frac{R_{Ch1}}{R_{Ch1} + R_{Ch2}} = 10A * \frac{3{,}4m\Omega}{3{,}4m\Omega + 4{,}2m\Omega} = 4{,}474A$$

die Größenordnung der Abweichung. Das Beispiel zeigt, dass eine Abweichung von $800\mu\Omega$ zwischen den Ausgangskanälen bereits eine Differenz von über einem Ampere hervorrufen kann. Weiters zu bedenken sei hierzu, dass der Strom quadratisch in die Verlustleistung des MOSFET eingeht.

Die Literatur beschreibt mehrere Möglichkeiten einen Lastausgleich in Parallelschaltungen vorzunehmen, wobei eher passive Methoden bevorzugt zu finden sind.

Wie Eingangs beschrieben, ist der Leitungswiderstand $R_{DS,on}$ von MOSFETs mit positivem Koeffizienten temperaturabhängig, d.h. mit steigender Temperatur wird der MOSFET zunehmend hochohmig. In einer Parallelschaltung führt dies zu einem natürlichen Lastausgleich, da jener MOSFET, der den höheren Strom führt auch höhere Verluste aufweist, welche das Bauteil stärker erwärmt.

Eine weitere gängige Methode ist, einen Ausgleich mittels zusätzlicher Widerstände zu erzwingen. Wählt man bspw. Shuntwiderstände in einer Größenordnung, dass die Leitungswiderstände der MOSFETs einen geringeren Einfluss haben, wird die Lastaufteilung im Wesentlichen von den Toleranzen der Shuntwiderstände bestimmt. Da derlei Widerstände prinzipbedingt geringe Toleranzen aufweisen, lassen sich dadurch gute Ergebnisse erzielen. Der Nachteil dieses Ansatzes liegt jedoch in der höheren Verlustleistung der Gesamtschaltung, die innerhalb eines Geräts abgeführt werden muss. Da diese Verluste quadratisch mit dem Strom eingehen, eignet sich diese Technik eher für Applikationen im Niederstrombereich.

EP2831990B1 beschreibt eine aktives Steuerverfahren zum Lastausgleich. In diesem Verfahren erfolgt der Lastausgleich durch abregeln der Ausgangsspannungen zumindest eines Leistungsteils an festgelegten Stromschwellen. Der Nachteil dieser Lösung ist ein höherer als unbedingt nötiger Spannungsabfall, um den Lastausgleich zu realisieren.

Die genannten Probleme der Parallelschaltung von Ausgangskanälen wurden vorstehend in Bezug auf elektronische Sicherungen beschrieben. Sie treten jedoch auch bei der Parallelschaltung von Ausgangskanälen von Stromversorgungsvorrichtungen im Allgemeinen auf.

Ausgehend vom zuvor beschriebenen Stand der Technik, liegt der Erfindung die Aufgabe zugrunde, eine Stromversorgungsvorrichtung, insbesondere eine elektronische Sicherung für eine Energieversorgung, anzugeben, die einen verlustarmen Lastausgleich in jedem beliebigen Arbeitspunkt ermöglicht.

Lösung der Aufgabe

Die Aufgabe wird gelöst durch eine Stromversorgungsvorrichtung, insbesondere eine elektronische Sicherung für eine Energieversorgung, umfassend eine erste Menge an Ausgangskanälen und eine Regeleinheit zum Lastausgleich zwischen den Ausgangskanälen der ersten Menge, wobei

- eine erste Anzahl an Ausgangskanälen in der ersten Menge größer gleich zwei ist,
- die Ausgangskanäle der ersten Menge jeweils einen Stromregler und ein Schaltelement umfassen,
- die Stromregler dazu ausgebildet sind, das Schaltelement in ihrem jeweiligen Ausgangskanal anzusteuern,
- die Ausgangskanäle der ersten Menge jeweils einen momentanen Ausgangsstrom und einen Nennstrom aufweisen,
- die Ausgangskanäle der ersten Menge parallel schaltbar sind,
  und wobei die Regeleinheit dazu ausgebildet ist, im Fall einer Parallelschaltung von zumindest zwei Ausgangskanälen der ersten Menge:
- die momentanen Ausgangsströme der Ausgangskanäle der ersten Menge zu erfassen,
- Ausgangskanal-Auslastungsgrade der Ausgangskanäle der ersten Menge zu ermitteln, wobei ein jeweiliger Ausgangskanal-Auslastungsgrad ein Verhältnis zwischen dem momentanen Ausgangsstrom und dem Nennstrom des jeweiligen Ausgangskanals ist,
- eine zweite Menge an Ausgangskanälen zu ermitteln, wobei die zweite Menge eine Teilmenge der ersten Menge ist, wobei eine zweite Anzahl der Ausgangskanäle in der zweiten Menge zumindest um eins kleiner ist als die erste Anzahl, wobei die zweite Menge zumindest jenen Ausgangskanal mit dem größten Ausgangskanal-Auslastungsgrad umfasst und zumindest jenen Ausgangskanal mit dem niedrigsten Ausgangskanal-Auslastungsgrad nicht umfasst, und
- die Stromregler der Ausgangskanäle der zweiten Menge derart anzusteuern, dass die Ausgangskanal-Auslastungsgrade der Ausgangskanäle der zweiten Menge abnehmen und ein Lastausgleich zwischen den Ausgangskanälen der ersten Menge stattfindet.

Der Hauptaspekt der Erfindung liegt darin, dass zumindest jener Ausgangskanal mit dem niedrigsten Ausgangskanal-Auslastungsgrad nicht von der zweiten Menge umfasst ist und damit nicht von der Regeleinheit für einen Lastausgleich geregelt wird. Dies sorgt dafür, dass dieser Ausgangskanal bei einem Abregeln eines oder mehrerer anderer Ausgangskanäle einen Strom übernimmt und dessen Ausgangskanal-Auslastungsgrad ansteigt, womit der Lastausgleich zwischen den Ausgangskanälen stattfindet. Außerdem ist damit in jeder Betriebslage die Last maßgeblich für den Ausgangsstrom.

Die Schaltelemente können auch jeweils ein Leistungsteil sein, der eine Mehrzahl an Bauelementen umfasst.

Die Anzahl an Ausgangskanälen in der zweiten Menge kann auch Eins sein, sodass die zweite Menge einen einzelnen Ausgangskanal umfasst.

Weiterhin ist es vorteilhaft, wenn die Schaltelemente elektronische Schalter sind, und wobei die Stromregler dazu ausgebildet sind, das Schaltelement in ihrem jeweiligen Ausgangskanal in einen Strombegrenzungsbetrieb zu versetzen und damit den momentanen Ausgangsstrom ihres jeweiligen Ausgangskanals zu begrenzen.

Durch diese Maßnahme wird ein optimaler und verlustarmer Lastausgleich ermöglicht.

Weiterhin ist es vorteilhaft, wenn der Strombegrenzungsbetrieb ein Linearbetrieb oder ein getakteter Betrieb ist.

Durch diese Maßnahme wird ein optimaler und verlustarmer Lastausgleich ermöglicht.

Weiterhin ist es vorteilhaft, wenn die elektronischen Schalter Feldeffekt-Transistoren, Bipolar-Transistoren oder IGBT sind.

Durch diese Maßnahme wird ein optimaler und verlustarmer Lastausgleich ermöglicht.

Weiterhin ist es vorteilhaft, wenn die Regeleinheit dazu ausgebildet ist, jedem Stromregler der zweiten Menge eine innere Führungsgröße vorzugeben, wobei die innere Führungsgröße ein Stromsollwert ist, der vom Ausgangskanal-Auslastungsgrad des dem Stromregler zugehörigen Ausgangskanals abhängig ist.

Durch diese Maßnahme wird die Stabilität der Regelung weiter erhöht und ein Lastausgleich rascher und verlustarmer ermöglicht.

Weiterhin ist es vorteilhaft, wenn die Stromregler der ersten Menge dazu ausgebildet sind, aus einer Differenz zwischen der inneren Führungsgröße und einer inneren Regelgröße, welche durch den momentanen Strom im jeweils zu den Stromreglern zugehörigen Ausgangskanal gebildet ist, eine innere Stellgröße für das Schaltelement in ihrem jeweiligen Ausgangskanal zu ermitteln.

Durch diese Maßnahme wird die Stabilität der Regelung weiter erhöht und ein Lastausgleich rascher und verlustarmer ermöglicht.

Weiterhin ist es vorteilhaft, wenn die Regeleinheit dazu ausgebildet ist, die innere Führungsgröße für die Stromregler der zweiten Menge aus einer Differenz zwischen einer äußeren Führungsgröße und einer dem jeweiligen Ausgangskanal der Stromregler zugeordneten äußeren Regelgröße zu ermitteln.

Durch diese Maßnahme wird die Stabilität der Regelung weiter erhöht und ein Lastausgleich rascher und verlustarmer ermöglicht.

Weiterhin ist es vorteilhaft, wenn die äußere Führungsgröße ein Gesamt-Auslastungsgrad der ersten Menge der Ausgangskanäle ist, wobei die Regeleinheit dazu ausgebildet ist, den Gesamt-Auslastungsgrad als Verhältnis zwischen der Summe der momentanen Ausgangsströme der Ausgangskanäle der ersten Menge zur Summe der Nennströme der Ausgangskanäle der ersten Menge zu bilden, und die dem Ausgangskanal zugeordnete äußere Regelgröße jeweils eine Differenz zwischen dem Gesamt-Auslastungsgrad und dem Ausgangskanal-Auslastungsgrad des Ausgangskanals ist.

Durch diese Maßnahme wird die Stabilität der Regelung weiter erhöht und ein Lastausgleich rascher und verlustarmer ermöglicht. Außerdem wird dadurch, dass jedem Ausgangskanal eine äußere Regelgröße zugeordnet wird, ermöglicht, dass eine Mehrzahl an äußeren Stellgrößen durch den Führungsregler gebildet werden kann, diese Mehrzahl an äußeren Stellgrößen als Mehrzahl an inneren Führungsgrößen an die Ausgangskanäle übermittelt werden kann und damit eine Mehrzahl an Ausgangskanälen individuell geregelt werden kann.

Weiterhin ist es vorteilhaft, wenn die äußere Führungsgröße ein arithmetischer Mittelwert der momentanen Ausgangsströme der Ausgangskanäle der ersten Menge ist, und die dem Ausgangskanal zugeordnete äußere Regelgröße eine Differenz der momentanen Ausgangsströme der Ausgangskanäle der ersten Menge ist.

Durch diese Maßnahme wird die Stabilität der Regelung weiter erhöht und ein Lastausgleich rascher und verlustarmer ermöglicht. Diese Maßnahme eignet sich außerdem in besonderer Weise für Ausgangskanäle mit ähnlichen Nennströmen.

Weiterhin ist es vorteilhaft, wenn die äußere Führungsgröße ein arithmetischer Mittelwert der momentanen Ausgangsströme der Ausgangskanäle der ersten Menge ist, und die dem Ausgangskanal zugeordnete äußere Regelgröße eine mittlere absolute Abweichung der momentanen Ausgangsströme der Ausgangskanäle der ersten Menge vom arithmetischen Mittelwert der momentanen Ausgangsströme der Ausgangskanäle der ersten Menge ist.

Durch diese Maßnahme wird die Stabilität der Regelung weiter erhöht und ein Lastausgleich rascher und verlustarmer ermöglicht. Diese Maßnahme eignet sich außerdem in besonderer Weise für einen Lastausgleich zwischen mehr als zwei Ausgangskanälen.

Weiterhin ist es vorteilhaft, wenn die Regeleinheit dazu ausgebildet ist, die Stromregler der Ausgangskanäle der zweiten Menge in Abhängigkeit von einem Erreichen oder Überschreiten eines Schwellwerts der äußeren Regelgröße anzusteuern.

Durch diese Maßnahme wird die Stabilität der Regelung weiter erhöht und ein Lastausgleich rascher und verlustarmer ermöglicht.

Weiterhin ist es vorteilhaft, wenn die Stromversorgungsvorrichtung eine elektronische Sicherung für eine Energieversorgung ist.

Die Stromversorgungsvorrichtung eignet sich in besonderer Weise für den Einsatz als eine elektronische Sicherung.

Figurenbeschreibung

Im Folgenden wird die Erfindung anhand der in den Figuren dargestellten Ausführungsbeispiele näher beschrieben und erläutert.

Es zeigen beispielhaft:

Fig. 1: Ein Schaltbild von zwei parallelen Zweigen einer elektronischen Sicherung,
Fig. 2: Ein Schaltbild einer beispielhaften ersten Ausführungsvariante einer erfindungsgemäßen elektronischen Sicherung,
Fig. 3: Ein Schaltbild einer beispielhaften zweiten Ausführungsvariante einer erfindungsgemäßen elektronischen Sicherung,
Fig. 4: Einen Stromverlauf zweier Ausgangskanäle einer erfindungsgemäßen elektronischen Sicherung in der zweiten Ausführungsvariante,
Fig. 5: Ein beispielhaftes Flussdiagramm von Schritten, die von der elektronischen Sicherung in der zweiten Ausführungsvariante ausgeführt werden, und
Fig. 6: Ein Schaltbild einer beispielhaften dritten Ausführungsvariante einer erfindungsgemäßen elektronischen Sicherung.

Fig. 2 zeigt ein Schaltbild einer beispielhaften ersten Ausführungsvariante einer erfindungsgemäßen elektronischen Sicherung ES. Die elektronische Sicherung ES umfasst eine erste Menge $M_1$ an Ausgangskanälen $Ch_1...Ch_n$. Dargestellt sind ein erster Ausgangskanal $Ch_1$, umfassend einen ersten Stromregler $REG-I_1$ und ein erstes Schaltelement $SE_1$, und ein n-ter Ausgangskanal $Ch_n$, umfassend einen n-ten Stromregler $REG-I_n$ und ein n-tes Schaltelement $SE_n$. Mit einem Schaltelement $SE_1...SE_n$ kann ein allgemeiner Leistungsteil bezeichnet sein. Die drei Punkte, die in Fig. 2 dargestellt sind, stehen symbolisch für weitere Ausgangskanäle, die von der ersten Menge $M_1$ umfasst sind. Dies stellt schematisch dar, dass eine Mehrzahl an Ausgangskanälen $Ch_1...Ch_n$ von der ersten Menge $M_1$ umfasst ist. Eine erste Anzahl $N_{M1}$ an Ausgangskanälen in der ersten Menge $M_1$ ist größer gleich zwei.

Die Ausgangskanäle $Ch_1...Ch_n$ der ersten Menge $M_1$ sind an deren Ausgängen parallel geschaltet und speisen gemeinsam eine Last Z. Über die Ausgangskanäle $Ch_1...Ch_n$ der ersten Menge $M_1$ ist jeweils eine Versorgungsspannung an einen dem jeweiligen Ausgangskanal $Ch_1...Ch_n$ zugeordneten Ausgang geführt.

Die Stromregler $REG-I_1...REG-I_n$, sind dazu ausgebildet, aus einer Differenz zwischen einer inneren Führungsgröße $FG-I_1...FG-I_n$ und einer inneren Regelgröße $RG-I_1...RG-I_n$ eine innere Stellgröße $SG-I_1...SG-I_N$ für das Schaltelement $SE_1...SE_n$ in ihrem Ausgangskanal $Ch_1...Ch_n$ zu ermitteln. Die innere Führungsgröße $FG-I_1...FG-I_n$ wird von einer Regeleinheit RE bzw. vom Führungsregler REG-F der Regeleinheit RE als äußere Stellgröße $SG-Ä_1...SG-Ä_n$ bereitgestellt. Die äußere Stellgröße $SG-Ä_1...SG-Ä_n$ ist dabei ein auf den jeweiligen Nennstrom $I_{Ch1,N}...I_{Chn,N}$ des Ausgangskanals $Ch_1...Ch_n$ bezogener Stromsollwert $i_{Ch1,Soll}...i_{Chn,Soll}$. In diesem Ausführungsbeispiel umfassen die Ausgangskanäle $Ch_1...Ch_n$ daher jeweils einen Entnormierer $x_n$, der den bezogenen Stromsollwert $i_{Ch1,Soll}...i_{Chn,Soll}$ in einen nicht-bezogenen bzw. entnormierten Stromsollwert $I_{Ch1,Soll}...I_{Chn,Soll}$ umwandelt. Die innere Regelgröße $RG-I_1...RG-I_n$ ist ein momentaner Ausgangsstrom $I_{Ch1}...I_{Chn}$ im jeweiligen Ausgangskanal $Ch_1...Ch_n$. Die innere Regelgröße $RG-I_1...RG-I_n$ bzw. der momentane Ausgangsstrom $I_{Ch1}...I_{Chn}$ wird über eine innere Regelschleife rückgeführt. Die Stromregler $REG-I_1...REG-I_n$ umfassen jeweils eine innere Regelschleife und bilden mit einer Regeleinheit RE eine Kaskadenregelung aus.

Weiters ist die Regeleinheit RE dargestellt. Die Regeleinheit RE ist den Stromreglern $REG-I_1...REG-I_n$ übergeordnet. Die Stromregler $REG-I_1...REG-I_n$ bilden mit der Regeleinheit eine Kaskadenregelung aus. Die Regeleinheit RE ermittelt eine zweite Menge $M_2$ an Ausgangskanälen $Ch_1...Ch_n$. Die zweite Menge $M_2$ ist eine Teilmenge der ersten Menge $M_1$, wobei eine zweite Anzahl $N_{M2}$ der Ausgangskanäle $Ch_1...Ch_n$ in der zweiten Menge $M_2$ zumindest um eins kleiner ist als die erste Anzahl $N_{M1}$, wobei die zweite Menge $M_2$ zumindest jenen Ausgangskanal $Ch_1...Ch_n$ mit dem größten Ausgangskanal-Auslastungsgrad $AG_{Ch1}...AG_{Chn}$ umfasst und zumindest jenen Ausgangskanal $Ch_1...Ch_n$ mit dem niedrigsten Ausgangskanal-Auslastungsgrad $AG_{Ch1}...AG_{Chn}$ nicht umfasst. Das heißt, dass für eine erste Anzahl $N_{M1}$ an Ausgangskanälen $Ch_1...Ch_n$ in der ersten Menge $M_1$ von beispielsweise zwei, eine zweite Anzahl $N_{M2}$ an Ausgangskanälen $Ch_1...Ch_n$ in der zweiten Menge $M_2$ beispielsweise eins ist. Für eine erste Anzahl $N_{M1}$ von beispielsweise drei ist eine zweite Anzahl $N_{M2}$ beispielsweise zwei oder eins. Dass zumindest jener Ausgangskanal $Ch_1...Ch_n$ mit dem niedrigsten Ausgangskanal-Auslastungsgrad $AG_{Ch1}...AG_{Chn}$ nicht von der zweiten Menge $M_2$ umfasst ist und damit nicht von der Regeleinheit RE für einen Lastausgleich geregelt wird sorgt dafür, dass dieser Ausgangskanal $Ch_1...Ch_n$ bei einem Abregeln eines oder mehrerer anderer Ausgangskanäle $Ch_1...Ch_n$ einen Strom übernimmt und dessen Ausgangskanal-Auslastungsgrad $AG_{Ch1}...AG_{Chn}$ ansteigt. Außerdem ist damit in jeder Betriebslage die Last maßgeblich für den Ausgangsstrom $I_Z$.

Die Regeleinheit RE umfasst in einen Führungsregler REG-F. Der Führungsregler REG-F ermittelt zumindest eine äußere Stellgröße $SG-Ä_1...SG-Ä_n$, welche als zumindest eine innere Führungsgröße $FG-I_1...FG-I_n$ den Stromreglern $REG-I_1...REG-I_n$ der Ausgangskanäle $Ch_1...Ch_n$ der zweiten Menge $M_2$ bereitgestellt wird. Die zumindest eine innere Führungsgröße $FG-I_1...FG-I_n$ entspricht dabei einem Stromsollwert $I_{Ch1,Soll}...I_{Chn,Soll}$ für den jeweiligen Ausgangskanal $Ch_1...Ch_n$. Der Führungsregler REG-F kann dabei für eine Mehrzahl an Ausgangskanälen $Ch_1...Ch_n$ unterschiedliche innere Führungsgrößen $FG-I_1...FG-I_n$ ermitteln und diese den Ausgangskanälen $Ch_1...Ch_n$ bereitstellen.

In diesem Ausführungsbeispiel ist die äußere Führungsgröße FG-Ä ein Gesamt-Auslastungsgrad $AG_{Ges}$ der ersten Menge $M_1$ der Ausgangskanäle $Ch_1...Ch_n$ ist, wobei die Regeleinheit RE dazu ausgebildet ist, den Gesamt-Auslastungsgrad $AG_{Ges}$ als Verhältnis zwischen der Summe der momentanen Ausgangsströme $ICh_1...ICh_n$ der Ausgangskanäle $Ch_1...Ch_n$ der ersten Menge $M_1$ zur Summe der Nennströme $I_{Ch1,N}...I_{Chn,N}$ der Ausgangskanäle $Ch_1...Ch_n$ der ersten Menge $M_1$ zu bilden, und die dem Ausgangskanal $Ch_1...Ch_n$ zugeordnete äußere Regelgröße $RG-Ä_1...RG-Ä_n$ jeweils eine Differenz zwischen dem Gesamt-Auslastungsgrad $AG_{Ges}$ und dem Ausgangskanal-Auslastungsgrad $AG_{Ch1}...AG_{Chn}$ des Ausgangskanals $Ch_1...Ch_n$. Die Ausgangskanal-Auslastungsgrade $AG_{Ch1}...AG_{Chn}$ werden durch eine Normierung bzw. einen Bezug jeweils des momentanen Ausgangsstroms $I_{Ch1}...I_{Chn}$ auf den Nennstrom $I_{Ch1,N}...I_{Chn,N}$ ermittelt. Die Differenzbildung ist in Fig. 2 schematisch dargestellt, d.h. es wird für die Ausgangskanäle $Ch_1...Ch_n$ jeweils eine Differenz zwischen dem Gesamt-Auslastungsgrad $AG_{Ges}$ und dem Ausgangskanal-Auslastungsgrad $I_{Ch1,Soll}...I_{Chn,Soll}$ gebildet. Alternativ könnte dieser Zusammenhang mit einer Mehrzahl an Differenzbildnern dargestellt werden.

Die Regeleinheit RE ist dazu ausgebildet, die zweite Menge $M_2$ anhand verschiedener Kriterien zu ermitteln. Diese Kriterien können beispielsweise die Ausgangskanal-Auslastungsgrade $AG_{Ch1}...AG_{Chn}$ der Ausgangskanäle $Ch_1...Ch_n$, die Abweichungen der Ausgangskanal-Auslastungsgrade $AG_{Ch1}...AG_{Chn}$ der Ausgangskanäle $Ch_1...Ch_n$ von einem Gesamt-Auslastungsgrad $AG_{Ges}$, das Erreichen oder Überschreiten eines Schwellwerts einer äußeren Regelgröße $RG-Ä_1...RG-Ä_n$ oder eine Temperatur in einem der Ausgangskanäle $Ch_1...Ch_n$ sein. Das Ergebnis der Ermittlung der zweiten Menge $M_2$ ist schematisch durch einen strichlierten Pfeil dargestellt, der auf einen schematisch dargestellten Schalter bzw. Umschalter wirkt. Dies soll darstellen, dass von der Regeleinheit RE bzw. vom Führungsregler REG-F für jeden Ausgangskanal $Ch_1...Ch_n$ der zweiten Menge eine äußere Stellgröße $SG-Ä_1...SG-Ä_n$ ermittelt wird und an den jeweiligen Ausgangskanal $Ch_1...Ch_n$ ausgegeben wird. Ist eine zweite Anzahl $N_{M2}$ an Ausgangskanälen $Ch_1...Ch_n$ in der zweiten Menge $M_2$ größer gleich zwei, so wird eine Mehrzahl an unterschiedlichen äußeren Stellgrößen $SG-Ä_1...SG-Ä_n$ ermittelt wird, die jeweils einem Ausgangskanal $Ch_1...Ch_n$ der zweiten Menge $M_2$ zugeordnet sind und an diesen ausgegeben werden. Die Regeleinheit RE bzw. der Führungsregler REG-F kann somit als Multiplexer angesehen werden, der aus unterschiedlichen Differenzen zwischen einer äußeren Führungsgröße FG-Ä und unterschiedlichen äußeren Regelgrößen $RG-Ä_1...RG-Ä_n$ jeweils unterschiedliche äußere Stellgrößen $SG-Ä_1...SG-Ä_n$ ermittelt und diese an den Ausgangskanal $Ch_1...Ch_n$ oder die Ausgangskanäle $Ch_1...Ch_n$ der zweiten Menge ausgibt.

Die jeweils inneren Führungs- $FG-I_1...FG-I_n$, Regel- $RG-I_1...RG-I_n$ und Stellgrößen $SG-I_1...SG-I_n$ können auch als unterlagerte Führungs-, Regel- und Stellgrößen bezeichnet werden, da sie in Regelkreisen wirken, die der übergeordneten Regeleinheit RE unterlagert sind. Die jeweils äußeren Führungs- FG-Ä, Regel- $RG-Ä_1...RG-Ä_n$ und Stellgrößen $SG-Ä_1...SG-Ä_n$ können auch als übergeordnete Führungs-, Regel- und Stellgrößen bezeichnet werden, die sie in der Regeleinheit RE und damit in den den Stromreglern $REG-I_1...REG-I_n$ übergeordneten Regelkreisen wirken.

Um einen geführten Lastausgleich vornehmen zu können, muss ein eigenes Regelkonzept, samt dazu angepassten Algorithmus, entwickelt werden. Die elektronische Sicherung ES umfasst Stromregler $REG-I_1...REG-I_n$ in analoger oder digitaler Form, um im Überlastfall Ströme begrenzen zu können. Der aktive Ausgleich im Ausgangskanal $Ch_1...Ch_n$ wird mit diesen Stromreglern $REG-I_1...REG-I_n$ und der Lastausgleich mit einem übergeordneten Kaskadenregler bzw. mit einer übergeordneten Regeleinheit RE durchgeführt.

In der übergeordneten Regeleinheit werden die Ströme $I_{Chn}$ in den einzelnen Ausgangskanälen $Ch_1...Ch_n$ gemessen und summiert. Damit sind die Ströme bezeichnet, die durch die Schaltelemente $SE_1...SE_n$ fließen. Da die Summe der Ströme in den einzelnen Ausgangskanälen $Ch_1...Ch_n$ den Laststrom Iz ergibt

$$I_Z = \sum_{k=1}^{n} I_{Chk}$$

lässt sich durch die Summe der einzelnen Nennwerte $I_{Chn,N}$

$$\sum_{k=1}^{n} I_{Chk,N}$$

durch Normierung ein Auslastungsgrad des Systems $AG_{Ges}$ bestimmen

$$AG_{Ges} = \frac{\sum_{k=1}^{n} I_{Chk}}{\sum_{k=1}^{n} I_{Chk,N}}$$

Dieser Wert stellt den aktuellen Auslastungsgrad $AG_{Ges}$ der elektronischen Sicherung ES zu jedem Zeitpunkt dar, da er mit wechselnder Last automatisch angepasst wird. Daher wird dieser normierte Wert als äußere Führungsgröße FG-Ä für den Lastausgleichsregler bzw. Führungsregler REG-F herangezogen. Prinzipiell eignet sich hier jede normierbare Größe, die Aufschluss auf die gewünschte Auslastung der elektronischen Sicherung ES gibt.

Gleichzeitig bzw. in unmittelbarer zeitlicher Nähe, werden die momentanen Ausgangsströme $I_{Ch1}...I_{Chn}$ in den Schaltelementen bzw. Ausgangskanälen $Ch_1...Ch_n$ mit ihrem Nennwert $I_{Ch1,N}...I_{Chn,N}$ normiert. Daraus lässt sich zunächst die Information gewinnen, inwieweit das einzelne Schaltelement $SE_1...SE_n$ bzw. der einzelne Ausgangskanal $Ch_1...Ch_n$ im Verhältnis zum jeweiligen Nennwert $i_{Chn}$ ausgelastet ist.

Anschließend wird durch Subtrahieren die Abweichung der Auslastung des jeweiligen Ausgangskanals zum Gesamt-Auslastungsgrad $AG_{Ges}$ der elektronischen Sicherung ES ermittelt

$$\Delta i_{Chk} = AG_{Ges} - i_{Chk}$$

Jener Ausgangskanal $Ch_1...Ch_n$, dessen Ausgangskanal-Auslastungsgrad $AG_{Ch1}...AG_{Chn}$ über dem (idealen) Gesamt-Auslastungsgrad $AG_{Ges}$ der elektronischen Sicherung ES liegt, führt relativ gesehen zu viel momentanen Ausgangsstrom $I_{Ch1}...I_{Chn}$ und wird abgeregelt.

Welcher Ausgangskanal $Ch_1...Ch_n$ relativ zum Gesamt-Auslastungsgrad $AG_{Ges}$ am höchsten belastet wird, lässt sich beispielsweise daran erkennen, dass die entsprechende Abweichung $\Delta_{iChn}$ negativ ($\Delta_{iChn} < 0$) ist. Diese Informationen werden einem Entscheider bzw. Schwellwerttrigger SWT zugeführt, welcher den Ausgangskanal $Ch_1...Ch_n$ bzw. das Schaltelement $SE_1...SE_n$ , der aktiv geregelt wird, auswählt. Bei Bedarf kann hier eine Schwelle mit vorgegeben werden, ab der die Regeleinheit RE bzw. der Führungsregler REG-F eingreift oder die vorgebbare Abweichung toleriert.

Die somit ermittelte relative Abweichung $\Delta_{iCh,ist}$ wird dem Führungsregler REG-F, neben der äußeren Führungsgröße FG-Ä bzw. in diesem Fall dem Gesamt-Auslastungsgrad $AG_{Ges}$, als Regelabweichung zugeführt. Dieser berechnet die normierte äußere Stellgröße $i_{Chk,soll}$, welche anschließend entnormiert, bspw. über einen DAC, dem Stromregler REG-$I_1$...REG-$I_n$ des Ausgangskanals $Ch_1...Ch_n$ zugeführt wird.

Ein wesentlicher Vorteil dieser Anordnung liegt darin, dass immer nur ein Ausgangskanal $Ch_1...Ch_n$ bzw. Schaltelement $SE_1...SE_n$ oder Leistungsteil sich aktiv im Regelbetrieb befindet. Da immer ein Ausgangskanal $Ch_1...Ch_n$ bzw. Schaltelement $SE_1...SE_n$ oder Leistungsteil voll durchgeschaltet bleibt, sinkt die Ausgangsspannung nicht ab.

Dadurch bleibt die Last in jeder Betriebslage maßgeblich für den Gesamtstrom $I_Z$, Lastsprünge sind jederzeit möglich, da die äußere Führungsgröße $AG_{Ges}$ durch die Normierung der Lastsituation nachgeführt wird.

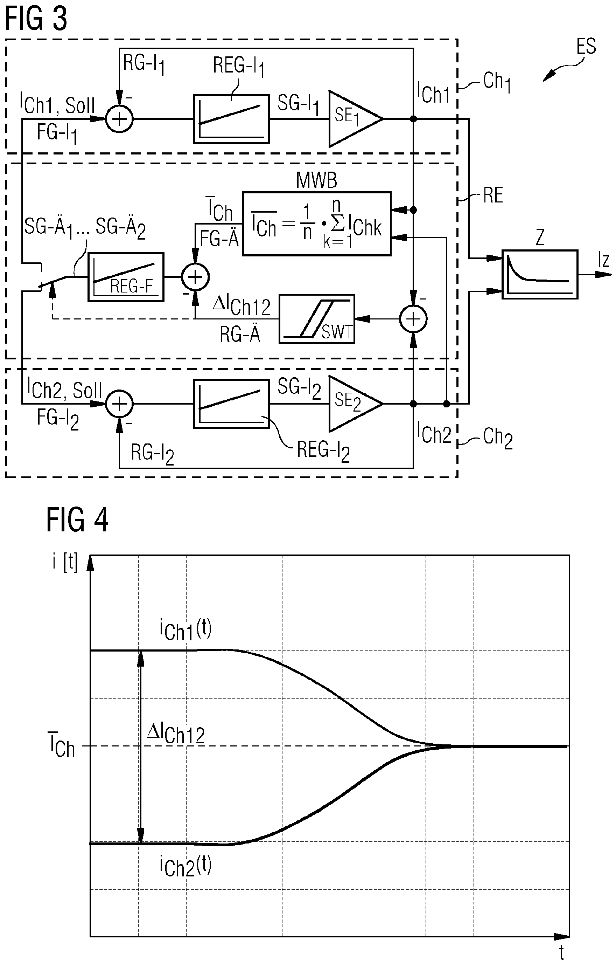

Fig. 3 zeigt ein Schaltbild einer beispielhaften zweiten Ausführungsvariante einer erfindungsgemäßen elektronischen Sicherung ES. Gezeigt ist eine Regeleinheit, zwei Ausgangskanäle $Ch_1...Ch_2$ und eine Last. Die beiden Ausgangskanäle $Ch_1...Ch_2$ sind parallel geschaltet und speisen gemeinsam die Last Z. Die Ausgangskanäle $Ch_1...Ch_2$ umfassen jeweils einen Stromregler REG-$I_1$...REG-$I_2$ und ein Schaltelement $SE_1...SE_2$. Die Regeleinheit RE ist in dieser Ausführungsform dazu ausgebildet, die äußere Führungsgröße FG-Ä als arithmetischer Mittelwert der momentanen Ausgangsströme $\bar{I}$ der Ausgangskanäle $Ch_1...Ch_2$ der ersten Menge $M_1$ zu bilden, und die dem Ausgangskanal $Ch_1...Ch_2$ zugeordnete äußere Regelgröße RG-Ä als eine Differenz $\Delta I_{Ch12}$ der momentanen Ausgangsströme $I_{Ch1}...I_{Ch2}$ der Ausgangskanäle $Ch_1...Ch_2$ der ersten Menge $M_1$ zu bilden. Die Regeleinheit RE ermittelt durch eine Differenz zwischen der äußeren Führungsgröße FG-Ä und der äußeren Regelgröße RG-Ä eine äußere Stellgröße SG-Ä$_1$...SG-Ä$_2$, welche als innere Führungsgröße FG-$I_1$...FG-$I_2$ dem Stromregler REG-$I_1$...REG-$I_2$ des Ausgangskanals $Ch_1...Ch_2$ der zweiten Menge $M_2$ übermittelt wird. Dieser Ausgangskanal $Ch_1...Ch_2$ ist in diesem Ausführungsbeispiel jener Ausgangskanal $Ch_1...Ch_2$ mit dem höheren Ausgangskanal-Auslastungsgrad $AG_{Ch1}...AG_{Ch2}$. Ob der Ausgangskanal geregelt wird, hängt auch davon ab, ob die Differenz $\Delta I_{Ch12}$ der momentanen Ausgangsströme $I_{Ch1}...I_{Ch2}$ der Ausgangskanäle $Ch_1...Ch_2$ der ersten Menge $M_1$ größer ist als ein vorgebbarer oder vorgegebener Schwellwert.

Die grundsätzliche Überlegung der Lastausgleichsregelung besteht darin, dass jener Ausgangskanal $Ch_1...Ch_2$, der den höheren Strom führt, zurückgeregelt wird.

Aus der Bauteilsicht führt jenes Schaltelement bzw. jener MOSFET den höheren Strom mit niedrigerem $R_{DS,on}$. Wie in der Einleitung beschrieben kann davon ausgegangen werden, dass es sich hierbei um jenes Schaltelement $SE_1...SE_2$ mit geringerer Betriebstemperatur handelt. Damit wird im Dauerbetrieb jener MOSFET vom Leitungsbetrieb in den Linearbetrieb geschickt, welcher ohnehin die geringere Temperatur aufweist. Sobald sich der MOSFET im Linearbetrieb durch die höhere Verlustleistung erwärmt, ist davon auszugehen, dass durch den steigenden $R_{DS,on}$ das Stromverteilungsverhältnis zwischen den Ausgangskanälen $Ch_1...Ch_2$ umgedreht wird. Der MOSFET im Leitungsbetrieb würde dann den höheren Strom übernehmen und dadurch geregelt werden. Damit ist ein thermischer Ausgleich zu erwarten und entsprechende Instabilitäten werden vermieden.

Die eigentliche Aufgabe der Stromregler $REG\text{-}I_1...REG\text{-}I_n$ in Stromversorgungsvorrichtungen oder elektronischen Sicherungen ES besteht darin, im Überlastfall den Strom auf einen vorgebbaren Wert zu begrenzen. Dieser eigentliche Sollwert der Stromregler $REG\text{-}I_1...REG\text{-}I_2$ liegt typischerweise beim 1, 5- bis 1, 8-fachen $I_{Nenn}$ und somit deutlich über den Nennstrom $I_{Ch1,N}...I_{Ch2,N}$ des Ausgangskanals $Ch_1...Ch_n$, bzw. über dem vorgebbaren Einstellwert. Der Grund hierfür liegt darin, dass im Betrieb auftretende Lastspitzen, welche den Anlagenbetrieb nicht gefährden, zugelassen werden sollen, ohne aktiv einzugreifen, da dies zu ungewünschten Effekten führen kann.

Würde ein Lastausgleich im Parallelbetrieb beide Ausgangskanäle $Ch_1...Ch_2$ gleichzeitig ansprechen und ebendiesen (gemeinsamen) Sollwert zurückregeln, wäre nur sehr schwer sicherzustellen, dass im Betrieb auftretende Überlasten ungewollt abgeregelt werden.

Aus diesen Gründen ist es sinnvoll die Regelung so auszuführen, dass immer nur ein MOSFET im Parallelverbund sich aktiv im Strombegrenzungs- bzw. Linearbetrieb befindet. Die Aufgabe der Regelung ist es, eine äußere Stellgröße $SG\text{-}Ä_1...SG\text{-}Ä_2$ zu ermitteln, welche über den äußeren Regelkreis bzw. die Regeleinheit RE bzw. den Führungsregler REG-F als Sollwert bzw. innere Führungsgröße $FG\text{-}I_1...FG\text{-}I_2$ dem inneren Regelkreis bzw. den Stromreglern $REG\text{-}I_1...REG\text{-}I_2$ übermittelt werden kann.

Die äußere Führungsgröße FG-Ä ist der Sollwert der äußeren Regelschleife der Kaskade bzw. der Regeleinheit RE und ist für einen Lastausgleich nicht trivial zu definieren. Ferner gilt dieselbe Fragestellung der äußeren Regelgröße $RG\text{-}Ä_1...RG\text{-}Ä_2$, schlussendlich muss erarbeitet werden, worauf geregelt wird, um einen Lastausgleich zwischen den Ausgangskanälen $Ch_1...Ch_2$ zu erzielen. Diese Überlegung ist in Fig. 4 dargestellt.

Fig. 4 zeigt einen Stromverlauf zweier Ausgangskanäle $Ch_1...Ch_2$ einer erfindungsgemäßen elektronischen Sicherung ES in der zweiten Ausführungsvariante bzw. den Ansatz den Mittelwert der momentanen Ausgangsströme beider Ausgangskanäle $Ch_1...Ch_2$ als äußere Führungsgröße FG-Ä zu definieren. Die Überlegung dahinter ist, dass jeder Ausgangskanal $Ch_1...Ch_2$ die Hälfte des Stroms führen soll. Bei n-kanäligen Systemen sollte jeder Ausgangskanal $Ch_1...Ch_n$ den gleichen Anteil im Verhältnis $1/n$ übernehmen, sofern die Ausgangskanäle $Ch_1...Ch_n$ gleich beschaffen sind, also beispielsweise den gleichen Nennstrom aufweisen.

Bei einer Parallelschaltung verschiedener Arten von Schaltelementen bzw. Transistortechnologien kann die Regelung so angepasst werden, dass sich die momentanen Ausgangsströme den Gegebenheiten entsprechend günstig aufteilen.

Die Mittelung der Ausgangsströme als äußere Führungsgröße FG-Ä hat zweierlei Vorteile. Der Laststrom wird durch den Verbraucher vorgegeben und kann sich im zeitlichen Verlauf auch ändern. Bei ungleicher Stromaufteilung in den Ausgangskanälen $Ch_1...Ch_n$ beeinflusst der Mittelwert der momentanen Ausgangsströme $I_{Ch1}...I_{Ch2}$ in den Ausgangskanälen $Ch_1...Ch_n$ den Summenstrom nicht, d.h. der Summenstrom, also der Strom Iz der durch die Last Z vorgegeben wird, entspricht sowohl der Summe der ungleichen momentanen Ausgangsströme $I_{Ch1}...I_{Ch2}$ in den Ausgangskanälen $Ch_1...Ch_2$ als auch dem doppelten Mittelwert $\bar{I}$.

$$I_Z = I_{Ch1} + I_{Ch2} = \bar{I}_{Ch}$$

Somit kann sichergestellt werden, dass die äußere Führungsgröße FG-Ä der sich zeitlich ändernden Last folgt. Schließlich folgt daraus der zweite Vorteil, dass durch eine zeitdiskrete Implementierung durch die Mittelung ein Vorfilter der äußeren Führungsgröße FG-Ä gleich mit implementiert wird, was Instabilitäten durch hohe dynamische Vorgänge vermeidet.

Aufbauend auf der Wahl des Mittelwerts der momentanen Ausgangsströme $\bar{I}$ in den Ausgangskanälen $Ch_1...Ch_2$ als äußere Führungsgröße FG-Ä wird die Differenz der momentanen Ausgangsströme $I_{Ch1}...I_{Ch2}$ zwischen den Ausgangskanälen $Ch_1...Ch_2$ als Regelabweichung (-differenz) und damit als äußere Regelgröße RG-Ä definiert. Durch den Verstärkungsfaktor kR des Reglers lässt sich die Dynamik der äußeren Regelschleife bestimmen.

Der Vorteil der Differenz der momentanen Ausgangsströme $I_{Ch1}...I_{Ch2}$ als Regeldifferenz liegt hierbei darin, dass sich daraus direkt wichtige Informationen für den Regelalgorithmus ableiten lassen. Wie bereits erwähnt zielt das Konzept darauf ab, dass immer jener Ausgangskanal $Ch_1...Ch_n$ geregelt wird, der den höheren momentanen Ausgangsstrom $I_{Ch1}...I_{Ch2}$ führt.

Ergibt die Berechnung der Regeldifferenz einen negativen Wert, bedeutet dies, dass es sich um den (ferner

einen) Ausgangskanal $Ch_1...Ch_2$ handeln muss, der einen geringeren momentanen Ausgangsstrom $I_{Ch1}...I_{Ch2}$ führt und damit nicht geregelt werden soll. Dies wird in Fig. 3 durch die strichlierte Linie dargestellt, die den Sollwertschalter betätigt.

Ein weiterer Vorteil dieses Ansatzes ist, dass ein Schwellwert eingeführt werden kann, ab dem der Führungsregler REG-F aktiv werden soll. Damit kann eine gewisse Unempfindlichkeit bei geringen Abweichungen erreicht werden. Typische Schwellwerte hierfür sind einige 100mA, bis hin zu wenigen Ampere in Hochstromanwendungen. Diese Ansprechschwelle kann jeweils an den Gegebenheiten flexibel angepasst werden.

Die Einführung einer Ansprechschwelle und das damit verbundene Tolerieren einer gewissen Regelabweichung erlaubt den Einsatz einfacher Reglertypen als Führungsregler REG-F, wie P-Regler. Diese einfachen Reglertypen wirken sich positiv auf die Regelstabilität der Kaskadenregelung aus, da der Phasengang des Führungsreglers REG-F dem System keine neuen Pole hinzufügt. Allerdings muss durch eine evtl. Anhebung oder Absenkung des Amplitudengangs berücksichtigt werden, dass dennoch eine Phasen- bzw. Amplitudenreserve beeinflusst wird.

In Anwendungen, bei denen eine geringere bzw. keine Regelabweichung toleriert werden kann, muss ein Reglertyp mit integriertem I-Anteil (sofern nicht von der Strecke enthalten) eingesetzt werden. Dabei ist jedoch auf die Stabilität der Regelung zu achten.

In einer alternativen Ausführung kann als Regelabweichung bzw. äußere Regelgröße FG-Ä auch die Differenz des momentanen Ausgangsstroms des Ausgangskanals $Ch_1...Ch_n$ zur äußeren Führungsgröße FG-Ä verwendet werden. Diese beinhaltet im Wesentlichen dieselben Informationen wie die Differenz der momentanen Ströme $I_{Ch1}...I_{Ch2}$ in den Ausgangskanälen $Ch_1...Ch_2$.

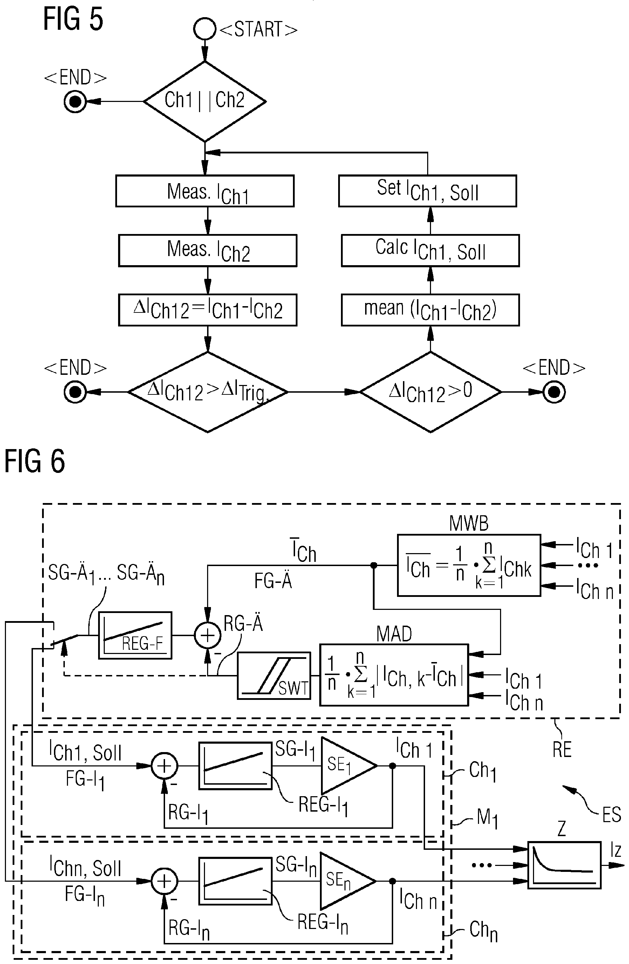

Fig. 5 zeigt ein beispielhaftes Flussdiagramm von Schritten, die von der elektronischen Sicherung ES in der zweiten Ausführungsvariante ausgeführt werden.

Diese Schritte werden vorzugsweise digital in einer Firmware umgesetzt, können aber auch bei Bedarf in anderer Form, beispielsweise analog, realisiert werden.

Zu Beginn wird überprüft, ob eine Parallelschaltung von zwei oder mehr Ausgangskanälen $Ch_1...Ch_n$ vorliegt. Dieser Schritt wird in allen Ausführungsvarianten durchgeführt und kann beispielsweise mit dem in EP4375680A1 geoffenbarten Verfahren erfolgen. Alternativ können beispielsweise Schalter oder Datenleitungen vorgesehen sein, mit denen eine Parallelschaltung von Ausgangskanälen $Ch_1...Ch_n$ der Stromversorgungsvorrichtung oder der elektronischen Sicherung ES bekanntgegeben werden kann.

Anschließend werden die momentanen Ausgangsströme $I_{Ch1}...I_{Ch2}$ der Ausgangskanäle $Ch_1...Ch_n$ gemessen und deren Differenz $\Delta I_{Ch12}$ berechnet. Liegt die Differenz über einem vorgebbaren oder vorgegebenen Schwellwert $\Delta I_{Trig}$ wird die Regeleinheit aktiv. Wie bereits beschrieben soll nur jener Ausgangskanal $Ch_1...Ch_n$ in den aktiven Regelbetrieb wechseln, der den höheren momentanen Ausgangsstrom $I_{Ch1}...I_{Ch2}$ führt bzw. den höheren Ausgangskanal-Auslastungsgrad $AG_{Ch1}...AG_{Ch2}$ aufweist. Dies wird beispielsweise über einen Größenvergleich oder dadurch überprüft, ob die Differenz positiv ist.

Ist eine der Bedingungen nicht erfüllt, wird der Vorgang abgebrochen. Sind die Vorbedingungen gegeben werden die Berechnungen für den jeweiligen Stromregler $REG-I_1...REG-I_2$ durchgeführt. Zunächst wird ein Sollwert als arithmetischen Mittelwert der momentanen Ausgangsströme $\bar{I}$ berechnet. Der Block "Calc $I_{Ch1,Soll}$" steht stellvertretend für eine Unterfunktion, in welcher der Führungsregler REG-F umgesetzt wird.

Da es sich um eine kaskadierte Regelung handelt, ist die äußere Stellgröße $SG-Ä_1...SG-Ä_2$, die Ausgangsgröße des Führungsreglers REG-F, der äußeren Reglerschleife gleichbedeutend mit dem Sollwert der inneren Reglerschleife, also der inneren Führungsgröße $FG-I_1...FG-I_2$. Daher die Bezeichnung "Calc $I_{Ch1,Soll}$". Die Realisierung der Regeleinheit RE bzw. des Führungsreglers REG-F ist Teil der Implementierung und richtet sich nach den Gegebenheiten der Applikation. Je nach Anforderung zur Regelgüte werden hier beginnend bei einfachen, nicht rekursiven Reglern (P-Regler) bis hin zu aufwändigen PID Reglern eingesetzt. Bei rekursiven Reglertypen sind neben der Berechnung der äußeren Stellgröße $SG-Ä_1...SG-Ä_2$ noch die Speicherung der rekursiven Werte als Zwischenschritte notwendig.

Schließlich wird als letzter Schritt die äußere Stellgröße $SG-Ä_1...SG-Ä_2$ dem inneren Regelkreis als Sollwert, also als innere Führungsgröße $FG-I_1...FG-I_2$, übertragen. Bei einer digitalen Umsetzung der äußeren Regelschleife, geschieht dies beispielsweise mittels eines Digital-Analog Wandlungsverfahren.

Fig. 6 zeigt ein Schaltbild einer beispielhaften dritten Ausführungsvariante einer erfindungsgemäßen elektronischen Sicherung.

Die äußere Führungsgröße FG-Ä ist dabei ein arithmetischer Mittelwert der momentanen Ausgangsströme $I_{Ch1}...I_{Chn}$ der Ausgangskanäle $Ch_1...Ch_n$ der ersten Menge $M_1$,
und die dem Ausgangskanal $Ch_1...Ch_n$ zugeordnete äußere Regelgröße $RG-Ä_1...RG-Ä_n$ eine mittlere absolute Abweichung der momentanen Ausgangsströme $I_{Ch1}...I_{Chn}$ der Ausgangskanäle $Ch_1...Ch_n$ der ersten Menge vom arithmetischen Mittelwert der momentanen Ausgangsströme $I_{Ch1}...I_{Chn}$ der Ausgangskanäle $Ch_1...Ch_n$ der ersten Menge $M_1$.

Ab drei Ausgangskanälen $Ch_1...Ch_n$ eignet sich hierfür die mittlere absolute Abweichung vom arithmetischen Mittel $d_{\bar{x}}$ (kur MAD, Mean Absolute Deviation). Diese wird von der Einheit zur Bildung der mittleren absoluten Abweichung vom arithmetischen Mittel gebildet. Die MAD ist definiert durch

$$d_{\bar{x}} = \frac{1}{n} \sum_{k=1}^{n} \left| i_{ch,n} - \bar{I}_{ch} \right|$$

und beschreibt somit die mittlere Abweichung des momentanen Ausgangsstroms jedes Ausgangskanals $Ch_1...Ch_n$ zum Mittelwert und ist damit eine gute Abbildung für die Regeldifferenz.

Für eine Implementierung mit mehreren Ausgangskanälen $Ch_1...Ch_n$ wird das Reglerkonzept angepasst werden. Das grundlegende Konzept der Kaskadenregelung bleibt aufrecht. Auch das Prinzip, dass jene Ausgangskanäle $Ch_1...Ch_n$, welche den höheren momentanen Ausgangsstrom $I_{Ch1}...I_{Chn}$ führen, abgeregelt werden, wird beibehalten.

Allerdings ergibt sich, ebenso wie in der ersten Ausführungsvariante, aus der höheren Anzahl der Ausgangskanäle $Ch_1...Ch_n$ der zusätzliche Freiheitsgrad, mehrere Ausgangskanäle $Ch_1...Ch_n$ aktiv zu regeln. Dem Schwellwerttrigger fällt damit die zusätzliche Aufgabe als Entscheider zu, welche Ausgangskanäle $Ch_1...Ch_n$ aktiv geregelt werden sollen. Darin besteht die Möglichkeit der Erweiterung eines MISO (Multiple Input Single Output) Systems zu einem MIMO (Multiple Input Multiple Output) System.

Der Regelalgorithmus würde sich jedoch nur unwesentlich verändern. Die Berechnung Regelabweichung erfolgt nicht mehr durch Differenzbildung, sondern durch Ermittlung der mittleren absoluten Abweichung vom arithmetischen Mittelwert MAD.

Die mittlere absolute Abweichung vom arithmetischen Mittelwert MAD beinhaltet im Wesentlichen dieselben Informationen für den Schwellwerttrigger, der dann ggf. einen Entscheider implementiert hätte, welche Ausgangskanäle $Ch_1...Ch_n$ nun aktiv geregelt werden.

Anschließend wird die äußere Stellgröße $SG\text{-}Ä_1...SG\text{-}Ä_n$ ermittelt und den entsprechenden Ausgangskanälen $Ch_1...Ch_n$ übertragen.

Bezugszeichenliste

| | |
|---|---|
| ES | Elektronische Sicherung |
| $Ch_1...Ch_n$ | Ausgangskanal |
| $REG\text{-}I_1...REG\text{-}I_n$ | Stromregler |
| $SE_1...SE_n$ | Schaltelement |
| $M_1$ | Erste Menge |
| $M_2$ | Zweite Menge |
| $N_{M1}$ | Erste Anzahl |
| $N_{M2}$ | Zweite Anzahl |
| $I_{Ch1}...I_{Chn}$ | Momentaner Ausgangsstrom |
| $I_{Ch1,N}...I_{Chn,N}$ | Nennstrom |
| $I_{Ch1,Soll}...I_{Chn,Soll}$ | Stromsollwert |
| $\bar{I}$ | Arithmetischer Mittelwert der momentanen Ausgangsströme |
| $AG_{Ch1}...AG_{Chn}$ | Ausgangskanal-Auslastungsgrad |
| $AG_{Ges}$ | Gesamt-Auslastungsgrad |
| REG-F | Führungsregler |
| $FG\text{-}I_1...FG\text{-}I_n$ | Innere Führungsgröße |
| $RG\text{-}I_1...RG\text{-}I_n$ | Innere Regelgröße |
| $SG\text{-}I_1...SG\text{-}I_n$ | Innere Stellgröße |
| FG-Ä | Äußere Führungsgröße |
| $RG\text{-}Ä_1...RG\text{-}Ä_n$ | Äußere Regelgröße |
| $SG\text{-}Ä_1...SG\text{-}Ä_n$ | Äußere Stellgröße |
| Z | Last |
| MWB | Mittelwertbildungseinheit |
| GAB | Gesamt-Auslastungsgrad-Bildungseinheit |
| SWT | Schwellwerttrigger-Einheit |
| MAD | Einheit zur Bildung der mittleren absoluten Abweichung vom arithmetischen Mittel |

**Patentansprüche**

1. Stromversorgungsvorrichtung, insbesondere eine elektronische Sicherung (ES) für eine Energieversorgung, um-

fassend eine erste Menge ($M_1$) an Ausgangskanälen ($Ch_1...Ch_n$) und eine Regeleinheit (RE) zum Lastausgleich zwischen den Ausgangskanälen ($Ch_1...Ch_n$) der ersten Menge ($M_1$), wobei

- eine erste Anzahl ($N_{M1}$) an Ausgangskanälen ($Ch_1...Ch_n$) in der ersten Menge ($M_1$) größer gleich zwei ist,
- die Ausgangskanäle ($Ch_1...Ch_n$) der ersten Menge ($M_1$) jeweils einen Stromregler ($REG-I_1...REG-I_n$) und ein Schaltelement ($SE_1...SE_n$) umfassen,
- die Stromregler ($REG-I_1...REG-I_n$) dazu ausgebildet sind, das Schaltelement ($SE_1...SE_n$) in ihrem jeweiligen Ausgangskanal ($Ch_1...Ch_n$) anzusteuern,
- die Ausgangskanäle ($Ch_1...Ch_n$) der ersten Menge ($M_1$) jeweils einen momentanen Ausgangsstrom ($I_{Ch1}...I_{Chn}$) und einen Nennstrom ($I_{Ch1,N}...I_{Chn,N}$) aufweisen,
- die Ausgangskanäle ($Ch_1...Ch_n$) der ersten Menge ($M_1$) parallel schaltbar sind, und wobei die Regeleinheit (RE) dazu ausgebildet ist, im Fall einer Parallelschaltung von zumindest zwei Ausgangskanälen ($Ch_1...Ch_n$) der ersten Menge ($M_1$):
- die momentanen Ausgangsströme ($I_{Ch1}...I_{Chn}$) der Ausgangskanäle ($Ch_1...Ch_n$) der ersten Menge ($M_1$) zu erfassen,
- Ausgangskanal-Auslastungsgrade ($AG_{Ch1}...AG_{Chn}$) der Ausgangskanäle ($Ch_1...Ch_n$) der ersten Menge ($M_1$) zu ermitteln, wobei ein jeweiliger Ausgangskanal-Auslastungsgrad ($AG_{Ch1}...AG_{Chn}$) ein Verhältnis zwischen dem momentanen Ausgangsstrom ($I_{Ch1}...I_{Chn}$) und dem Nennstrom ($I_{Ch1,N}...I_{Chn,N}$) des jeweiligen Ausgangskanals ($Ch_1...Ch_n$) ist,
- eine zweite Menge ($M_2$) an Ausgangskanälen ($Ch_1...Ch_n$) zu ermitteln, wobei die zweite Menge ($M_2$) eine Teilmenge der ersten Menge ($M_1$) ist, wobei eine zweite Anzahl ($N_{M2}$) der Ausgangskanäle ($Ch_1...Ch_n$) in der zweiten Menge ($M_2$) zumindest um eins kleiner ist als die erste Anzahl ($N_{M1}$), wobei die zweite Menge ($M_2$) zumindest jenen Ausgangskanal ($Ch_1...Ch_n$) mit dem größten Ausgangskanal-Auslastungsgrad ($AG_{Ch1}...AG_{Chn}$) umfasst und zumindest jenen Ausgangskanal ($Ch_1...Ch_n$) mit dem niedrigsten Ausgangs-kanal-Auslastungsgrad ($AG_{Ch1}...AG_{Chn}$) nicht umfasst, und
- die Stromregler ($REG-I_1...REG-I_n$) der Ausgangskanäle ($Ch_1...Ch_n$) der zweiten Menge ($M_2$) derart anzu-steuern, dass die Ausgangskanal-Auslastungsgrade ($AG_{Ch1}...AG_{Chn}$) der Ausgangskanäle ($Ch_1...Ch_n$) der zweiten Menge ($M_2$) abnehmen und ein Lastausgleich zwischen den Ausgangskanälen ($Ch_1...Ch_n$) der ersten Menge ($M_1$) stattfindet.

2. Stromversorgungsvorrichtung nach Anspruch 1, wobei die Schaltelemente ($SE_1...SE_n$) elektronische Schalter sind, und wobei die Stromregler ($REG-I_1...REG-I_n$) dazu ausgebildet sind, das Schaltelement ($SE_1...SE_n$) in ihrem jeweiligen Ausgangskanal ($Ch_1...Ch_n$) in einen Strombegrenzungsbetrieb zu versetzen und damit den momentanen Ausgangsstrom ($I_{Ch1}...I_{Chn}$) ihres jeweiligen Ausgangskanals ($Ch_1...Ch_n$) zu begrenzen.

3. Stromversorgungsvorrichtung nach Anspruch 2, wobei der Strombegrenzungsbetrieb ein Linearbetrieb oder ein getakteter Betrieb ist.

4. Stromversorgungsvorrichtung nach Anspruch 2 oder 3, wobei die elektronischen Schalter ($SE_1...SE_n$) Feldeffekt-Transistoren, Bipolar-Transistoren oder IGBT sind.

5. Stromversorgungsvorrichtung nach einem der Ansprüche 1 bis 4, wobei die Regeleinheit (RE) dazu ausgebildet ist, jedem Stromregler ($REG-I_1...REG-I_n$) der zweiten Menge ($M_2$) eine innere Führungsgröße ($FG-I_1...FG-I_n$) vorzu-geben, wobei die innere Führungsgröße ($FG-I_1...FG-I_n$) ein Stromsollwert ($I_{Ch1,Soll}...I_{Chn,Soll}$) ist, der vom Ausgangskanal-Auslastungsgrad ($AG_{Ch1}...AG_{Chn}$) des dem Stromregler ($REG-I_{Ch1}...REG-I_{Chn}$) zugehörigen Ausgangskanals ($Ch_1...Ch_n$) abhängig ist.

6. Stromversorgungsvorrichtung nach Anspruch 5, wobei die Stromregler ($REG-I_1...REG-I_n$) der ersten Menge ($M_1$) dazu ausgebildet sind, aus einer Differenz zwischen der inneren Führungsgröße ($FG-I_1...FG-I_n$) und einer inneren Regelgröße ($RG-I_1...RG-I_n$), welche durch den momentanen Strom ($I_{Ch1}...I_{Chn}$) im jeweils zu den Stromreglern ($REG-I_1...REG-I_n$) zugehörigen Ausgangskanal ($Ch_1...Ch_n$) gebildet ist, eine innere Stellgröße ($SG-I_1...SG-I_n$) für das Schaltelement ($SE_1...SE_n$) in ihrem jeweiligen Ausgangskanal ($Ch_1...Ch_n$) zu ermitteln.

7. Stromversorgungsvorrichtung nach Anspruch 5 oder 6, wobei die Regeleinheit (RE) dazu ausgebildet ist, die innere Führungsgröße ($FG-I_1...FG-I_n$) für die Stromregler ($REG-I_1...REG-I_n$) der zweiten Menge ($M_2$) aus einer Differenz zwischen einer äußeren Führungsgröße (FG-Ä) und einer dem jeweiligen Ausgangskanal ($Ch_1...Ch_n$) der Strom-regler ($REG-I_1...REG-I_n$) zugeordneten äußeren Regelgröße ($RG-Ä_1...RG-Ä_n$) zu ermitteln.

8. Stromversorgungsvorrichtung nach Anspruch 7,

- wobei die äußere Führungsgröße (FG-Ä) ein Gesamt-Auslastungsgrad ($AG_{Ges}$) der ersten Menge ($M_1$) der Ausgangskanäle ($Ch_1...Ch_n$) ist, wobei die Regeleinheit (RE) dazu ausgebildet ist, den Gesamt-Auslastungsgrad ($AG_{Ges}$) als Verhältnis zwischen der Summe der momentanen Ausgangsströme ($I_{Ch1}...I_{Chn}$) der Ausgangskanäle ($Ch_1...Ch_n$) der ersten Menge ($M_1$) zur Summe der Nennströme ($I_{Ch1,N}...I_{Chn,N}$) der Ausgangskanäle ($Ch_1...Ch_n$) der ersten Menge ($M_1$) zu bilden,
- und die dem Ausgangskanal ($Ch_1...Ch_n$) zugeordnete äußere Regelgröße ($RG\text{-}Ä_1...RG\text{-}Ä_n$) jeweils eine Differenz zwischen dem Gesamt-Auslastungsgrad ($AG_{Ges}$) und dem Ausgangskanal-Auslastungsgrad des Ausgangskanals ($Ch_1...Ch_n$) ist.

9. Stromversorgungsvorrichtung nach Anspruch 7,

- wobei die äußere Führungsgröße (FG-Ä) ein arithmetischer Mittelwert der momentanen Ausgangsströme ($I_{Ch1}...I_{Chn}$) der Ausgangskanäle ($Ch_1...Ch_n$) der ersten Menge ($M_1$) ist,
- und die dem Ausgangskanal ($Ch_1...Ch_n$) zugeordnete äußere Regelgröße ($RG\text{-}Ä_1...RG\text{-}Ä_n$) eine Differenz der momentanen Ausgangsströme ($I_{Ch1}...I_{Chn}$) der Ausgangskanäle ($Ch_1...Ch_n$) der ersten Menge ($M_1$) ist.

10. Stromversorgungsvorrichtung nach Anspruch 7,

- wobei die äußere Führungsgröße (FG-Ä) ein arithmetischer Mittelwert der momentanen Ausgangsströme ($I_{Ch1}...I_{Chn}$) der Ausgangskanäle ($Ch_1...Ch_n$) der ersten Menge ($M_1$) ist,
- und die dem Ausgangskanal ($Ch_1...Ch_n$) zugeordnete äußere Regelgröße ($RG\text{-}Ä_1...RG\text{-}Ä_n$) eine mittlere absolute Abweichung der momentanen Ausgangsströme ($I_{Ch1}...I_{Chn}$) der Ausgangskanäle ($Ch_1...Ch_n$) der ersten Menge vom arithmetischen Mittelwert der momentanen Ausgangsströme ($I_{Ch1}...I_{Chn}$) der Ausgangskanäle ($Ch_1...Ch_n$) der ersten Menge ($M_1$) ist.

11. Stromversorgungsvorrichtung nach einem der Ansprüche 7 bis 10, wobei die Regeleinheit (RE) dazu ausgebildet ist, die Stromregler ($REG\text{-}I_1...REG\text{-}I_n$) der Ausgangskanäle ($Ch_1...Ch_n$) der zweiten Menge ($M_2$) in Abhängigkeit von einem Erreichen oder Überschreiten eines Schwellwerts der äußeren Regelgröße ($RG\text{-}Ä_1...RG\text{-}Ä_n$) anzusteuern.

12. Stromversorgungsvorrichtung nach einem der vorangehenden Ansprüche, wobei die Stromversorgungsvorrichtung eine elektronische Sicherung (ES) für eine Energieversorgung ist.

## FIG 1

## FIG 2

## FIG 3

## FIG 4

## FIG 5

## FIG 6

Europäisches
Patentamt
European
Patent Office
Office européen
des brevets

# EUROPÄISCHER RECHERCHENBERICHT

Nummer der Anmeldung

EP 24 18 6850

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | US 2024/063627 A1 (WU WENKAI [US] ET AL) 22. Februar 2024 (2024-02-22) * Absätze [0007], [0009], [0010], [0011], [0012], [0031] - [0035]; Abbildung 1 * ----- | 1-12 | INV. H02H3/087 H03K17/12 H03K17/082 H03K17/14 |
| A | DE 10 2021 200343 A1 (VITESCO TECHNOLOGIES GERMANY GMBH [DE]) 21. Juli 2022 (2022-07-21) * Absätze [0004] - [0018], [0035] - [0037]; Abbildungen 1-4 * ----- | 1-12 | |
| A | US 11 264 983 B1 (KAYA CETIN [US] ET AL) 1. März 2022 (2022-03-01) * Zusammenfassung; Abbildung 1 * * Spalte 3, Zeilen 10-38 * * Spalte 4, Zeilen 13-30 * ----- | 1-12 | |
| A | WO 2020/193466 A1 (EATON INTELLIGENT POWER LTD [IE]) 1. Oktober 2020 (2020-10-01) * Absätze [0635] - [0637] * ----- | 1-12 | |
| A | CN 116 706 830 A (SUZHOU INSPUR INTELLIGENT TECH CO LTD) 5. September 2023 (2023-09-05) * Zusammenfassung; Abbildung 3 * ----- | 1-12 | RECHERCHIERTE SACHGEBIETE (IPC) H03K H02H H02M |

Der vorliegende Recherchenbericht wurde für alle Patentansprüche erstellt

| Recherchenort | Abschlußdatum der Recherche | Prüfer |
|---|---|---|
| München | 24. Januar 2025 | Palukova, Mila |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument
..............................................................................
& : Mitglied der gleichen Patentfamilie, übereinstimmendes
Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

`EP 24 18 6850`

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

`24-01-2025`

| Im Recherchenbericht angeführtes Patentdokument | Datum der Veröffentlichung | Mitglied(er) der Patentfamilie | Datum der Veröffentlichung |
|---|---|---|---|
| US 2024063627 A1 | 22-02-2024 | KEINE | |
| DE 102021200343 A1 | 21-07-2022 | KEINE | |
| US 11264983 B1 | 01-03-2022 | CN 116368734 A<br>DE 112021005775 T5<br>US 11264983 B1<br>WO 2022094368 A1 | 30-06-2023<br>21-09-2023<br>01-03-2022<br>05-05-2022 |
| WO 2020193466 A1 | 01-10-2020 | EP 3942662 A1<br>WO 2020193466 A1 | 26-01-2022<br>01-10-2020 |
| CN 116706830 A | 05-09-2023 | KEINE | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2831990 B1

- EP 4375680 A1